(19)

Europäisches
Patentamt
European
Patent Office
Office européen
des brevets

(11)  **EP 3 260 515 A1**

(12)  **EUROPEAN PATENT APPLICATION**

(43) Date of publication:
**27.12.2017  Bulletin 2017/52**

(51) Int Cl.:
*C09K 3/14* (2006.01)      *B24B 37/04* (2012.01)
*C09G 1/02* (2006.01)      *H01L 21/321* (2006.01)
*H01L 21/3105* (2006.01)

(21) Application number: **17001186.0**

(22) Date of filing: **11.08.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.09.2013  JP 2013195270
30.09.2013  JP 2013204183**

(62) Document number(s) of the earlier application(s) in
accordance with Art. 76 EPC:
**14845098.4 / 3 048 152**

(71) Applicant: **Fujimi Incorporated
Kiyosu-shi, Aichi 452-8502 (JP)**

(72) Inventors:
• **Shota, Suzuki
Kiyosu-shi Aichi, 452-8502 (JP)**
• **Yoshihiro, Izawa
Kiyosu-shi Aichi, 452-8502 (JP)**

(74) Representative: **Grünecker Patent- und
Rechtsanwälte
PartG mbB
Leopoldstraße 4
80802 München (DE)**

Remarks:
This application was filed on 12-07-2017 as a
divisional application to the application mentioned
under INID code 62.

(54)  **POLISHING COMPOSITION**

(57)    The present invention is the invention of a polishing composition comprising a silica in which a functional group satisfying at least one of condition (1) and condition (2) described below is fixed on the surface, and a pH-adjusting agent; condition (1): the functional group has an amino group; and condition (2): the functional group has a halogeno group, and the polishing composition of the invention can sufficiently control a polishing rate of a Si-containing material.

## Description

### TECHNICAL FIELD

The present invention relates to a polishing composition for use in a semiconductor device manufacturing process, and to a polishing method using the same.

### BACKGROUND ART

In recent years, new fine processing techniques have been developed along with high integration and high performance of large scale integration (LSI). One of such techniques is called chemical mechanical polishing (CMP) technique. CMP technique is frequently used during an LSI manufacturing process, in particular, during planarization of an interlayer insulation film, metal plug formation, and formation of embedded wiring (damascene wiring), in a multilayer wiring formation process. This technique is disclosed, for example, in Patent Literature 1.

In recent years, CMP has been more generally applied to various processes in semiconductor fabrication. One aspect thereof is, for example, application to a gate formation process in transistor fabrication.

During transistor fabrication, polishing may be performed on Si-containing materials such as polycrystalline silicon (polysilicon) and silicon nitride. In such a case, it is requested that the polishing rate of each Si-containing material needs to be controlled. For example, Patent Literature 2 discloses a polishing composition having a pH in a range from 2.5 to 5, and containing a colloidal silica, and an organic acid having a sulfonic acid group or a phosphonic acid group. Patent Literature 2 describes that use of such a polishing composition for, for example, polishing different Si-containing materials such as silicon nitride and polysilicon permits the polishing rate of a layer containing silicon nitride to be increased, and permits polishing of layers containing silicon-based compounds, such as polysilicon, modified polysilicon, silicon oxide, silicon carbide, and silicon oxycarbide, to be selectively suppressed.

Citation List

Patent Literatures

Patent Literature 1: US Patent No. 4944836

Patent Literature 2: JP 2010-041037 A

### SUMMARY OF INVENTION

Technical Problem

However, even with the polishing composition described in Patent Literature 2 above, the polishing rates of Si-containing materials cannot be controlled to a sufficient degree, and further improvement is thus desired.

Therefore, it is an object of the present invention to provide a polishing composition capable of controlling a polishing rate of a Si-containing material to a sufficient degree.

Solution to Problem

The present inventors conducted extensive studies to solve the problem described above. As a result, they found that the above problems can be solved, surprisingly, by fixing a specific function group on a silica surface. Based on this finding, the present invention is completed.

That is, the present invention is a polishing composition containing:

a silica in which a functional group satisfying at least one of condition (1) and condition (2) below is fixed on a surface thereof:

condition (1): the functional group has an amino group; and,
condition (2) : the functional group has a halogeno group; and,

a pH-adjusting agent.

Advantageous Effect of Invention

According to the present invention, a polishing composition capable of controlling a polishing rate of a Si-containing material to a sufficient degree can be provided.

DESCRIPTION OF EMBODIMENTS

The present invention will now be described below. The present invention is not limited to the embodiments described below. As used herein, a range expression of "X - Y" means a range of X or more to Y or less. Unless otherwise specified, operation and measurement of physical properties are performed under the following conditions: room temperature of 20 to 25°C and relative humidity of 40 to 50%.

<Polishing Composition>

A first aspect of the present invention is a polishing composition which includes a silica having a functional group satisfying at least one of condition (1) and condition (2) below fixed on a surface thereof (hereinafter also referred to as "silica in which a specific functional group is fixed on a surface thereof, " or simply "silica"), and a pH-adjusting agent:

condition (1) : the functional group has an amino group; and,
condition (2) : the functional group has a halogeno group.

A polishing composition of the present invention is capable of controlling a polishing rate of a Si-containing material to a sufficient degree. Whereas the detailed reason for such an effect is yet unknown, the following mechanism is presumed.

When the functional group that is fixed on a surface of the silica contained in the polishing composition satisfies condition (1) (i.e., the functional group includes an amino group), use of the polishing composition may result in a lower polishing rate of silicon nitride. By fixing a functional group having an amino group on the silica surface, the zeta potential value of the silica having the fixed functional group differs from the value of the original silica; the zeta potential has the same code of the zeta potential of the silicon nitride; As a result, the silica in which a functional group having an amino group is fixed on a surface thereof and the silicon nitride are electrostatically repelled; therefore, it is presumed that frequency of contact is reduced so that polishing is suppressed.

Meanwhile, when the functional group that is fixed on the silica contained in the polishing composition satisfies condition (2) (i.e., the functional group includes a halogeno group), polishing selectivity of the polycrystalline silicon to the silicon nitride may be improved (that is, selection ratio (= polishing rate of polycrystalline silicon / polishing rate of silicon nitride) may be increased). By fixing a functional group having a halogeno group on the silica surface, a nucleophilic addition reaction between the polycrystalline silicon which is a polishing object and the halogeno group is performed, and a silicon atom and the halogeno group are bounded to each other. This, then, weakens bonds between silicon atoms in the polycrystalline silicon, thereby making the bonds easy to break. Therefore, it is presumed that the polishing rate of the polycrystalline silicon improves.

Meanwhile, it is presumed that a nucleophilic addition reaction also occurs between the silicon nitride and the halogeno group to bond together a silicon atom and the halogeno group; however, since silicon nitride is a strongly-bonded crystalline material, the polishing rate is not as high as that of the polycrystalline silicon.

Note that the mechanism described above is based on a hypothesis, and that the present invention is by no means limited to the mechanism described above.

[Silica]

A polishing composition of the present invention essentially contains a silica in which a functional group satisfying at least one of condition (1) and condition (2) is fixed on a surface thereof. The silica functions as abrasive grain in the polishing composition.

The silica of the present invention may be fixed a functional group satisfying at least one of condition (1) and condition (2) on the surface. That is, the silica of the present invention includes (i) a silica in which only a functional group having an amino group is fixed on a surface thereof; (ii) a silica in which only a functional group having a halogeno group is fixed on a surface thereof; (iii) a silica in which a functional group having both an amino group and a halogeno group is fixed on a surface thereof; and (iv) a silica in which both a functional group having an amino group and a functional group having a halogeno group are fixed on a surf ace thereof. Among these, from a viewpoint of stability of the composition, cases (i) and (ii) are preferred. Description will be presented below in terms of cases (i) and (ii).

Silica that serves as a raw material before a functional group being fixed (hereinafter also referred to simply as "raw material silica") is not particularly limited. Examples thereof include, for example, a fumed silica and a colloidal silica. Among these, the colloidal silica is preferred from a viewpoint of dispersion stability of abrasive grain in the polishing composition.

In a case of a silica in which a functional group having an amino group is fixed on a surface thereof (above-mentioned case (i)), the functional group having an amino group is chemically bonded (e.g., covalently bonded) to a silica surface.

The functional group having an amino group is not particularly limited, and may consist only of an amino group, or may have a configuration in which an amino group is bonded to a linker structure. In the latter case, one functional group may have only one amino group or may have multiple amino groups. Although the linker structure is not particularly limited also, a linear or branched alkylene group ($-C_nH_{2n}-$) or oxyalkylene group ($-OC_nH_{2n}-$) or an arylene group, each having 2 to 5 carbon atoms, or a combination thereof is preferred from a viewpoint of dispersion stability and reactivity of abrasive grain in the polishing composition. Specific examples of the functional group having an amino group include functional groups from silane coupling agents described hereafter.

In a case of a silica in which a functional group having a halogeno group is fixed ona surface thereof (above-mentioned case (ii)), the functional group having a halogeno group is chemically bonded (e.g., covalently bonded) to a silica surface.

Examples of the halogeno group include a fluoro group (-F), a chloro group (-Cl), a bromo group (-Br), and an iodo group (-I). Among these, from a viewpoint of safety of the composition, a chloro group, a bromo group, and an iodo group are preferred, and a chloro group and a bromo group are more preferred.

The functional group having a halogeno group is not particularly limited, and may consist only of a halogeno group, or may have a configuration in which a halogeno group is bonded to a linker structure. In the latter case, one functional group may have one halogeno group or may have multiple halogeno groups, in this case, the halogeno groups may be one kind of halogeno group or a combination of two or more kinds of halogeno groups. While the linker structure is not particularly limited either, a linear or branched alkylene group ($-C_nH_{2n}-$) or oxyalkylene group ($-OC_nH_{2n}-$) having 2 to 5 carbon atoms, or an arylene group, or a combination thereof is preferred from a viewpoint of dispersion stability and reactivity of abrasive grain in the polishing composition. Specific examples of the functional group having a halogeno group include functional groups derived from silane coupling agents described later herein.

In the silica, secondary particles are generally formed by aggregating primary particles formed of $SiO_2$. The silica of the present invention in which a specific functional group is fixed on a surface thereof has an average primary particle size of preferably 5 nm or more, more preferably 7 nm or more, and still more preferably 10 nm or more. There is an advantage of improving the polishing rate of polishing object by the polishing composition as the average primary particle size is increased.

Meanwhile, a silica in which a specific functional group is fixed on a surface thereof has an average primary particle size of preferably 150 nm or less, more preferably 120 nm or less, and still more preferably 100 nm or less. There is an advantage of preventing occurrence of scratches on the surface of polishing object after being polished using the polishing composition as the average primary particle size is decreased. The value of average primary particle size is calculated based on a specific surface area measured with a BET method.

The silica of the present invention in which a specific functional group is fixed on a surface thereof has an average secondary particle size of preferably 10 nm or more, more preferably 15 nm or more, and still more preferably 20 nm or more. There is an advantage of improving the polishing rate of polishing object by the polishing composition as the average secondary particle size is increased.

Meanwhile, a silica in which a specific functional group is fixed on a surface thereof has an average secondary particle size of preferably 200 nm or less, more preferably 180 nm or less, and still more preferably 150 nm or less. There is an advantage of preventing occurrence of scratches on the surface of polishing object after being polished using the polishing composition as the average primary particle size is decreased. The value of average secondary particle size is calculated based on a specific surface area measured with a light scattering method using laser light.

A synthetic product or a commercial product may be used as the silica of the present invention in which a specific functional group is fixed on a surface thereof. A silica in which a specific functional group is fixed on a surface thereof may be used alone or in combination of two or more thereof.

[Method for Producing Silica]

There are no specific limitations on the method for producing the silica of the present invention in which a specific functional group is fixed on a surface thereof. However, the silica can be produced, for example, by adding and reacting a silane coupling agent having the specific functional group to the raw material silica, and bonding the specific functional group to a surface of the silica.

A silane coupling agent having an amino group is not particularly limited. Specific examples thereof include, for example, (aminopropyl)trialkoxy silanes, such as (3-aminopropyl)triethoxy silane, (3-aminopropyl)tripropoxy silane, and (3-aminopropyl)tributoxy silane; (aminopropyl)alkyl dialkoxy silanes, such as (3-aminopropyl)methyl dimethoxy silane, (3-aminopropyl)methyl diethoxy silane, (3-aminopropyl)methyl dipropoxy silane, (3-aminopropyl)methyl dibutoxy silane, (3-aminopropyl)ethyl dimethoxy silane, (3-aminopropyl)propyl dimethoxy silane, (3-aminopropyl)butyl dimethoxy silane, (3-aminopropyl)ethyl diethoxy silane, (3-aminopropyl)propyl diethoxy silane, (3-aminopropyl)butyl diethoxy silane, (3-aminopropyl)ethyl dipropoxy silane, (3-aminopropyl)propyl dipropoxy silane, (3-aminopropyl)butyl dipropoxy silane, (3-aminopropyl)ethyl dibutoxy silane, (3-aminopropyl)propyl dibutoxy silane, and (3-aminopropyl) butyl dibutoxy silane; (aminopropyl) dialkyl alkoxy silanes, such as (3-aminopropyl)dimethyl methoxy silane, (3-aminopropyl)diethyl methoxy silane, (3-aminopropyl)dipropyl methoxy silane, (3-aminopropyl)dibutyl methoxy silane, (3-aminopropyl)dimethyl ethoxy silane, (3-aminopropyl)diethyl ethoxy silane, (3-aminopropyl)dipropyl ethoxy silane, (3-aminopropyl)dibutyl ethoxy silane, (3-aminopropyl)dimethyl propoxy silane, (3-aminopropyl)diethyl propoxy silane, (3-aminopropyl)dipropyl propoxy silane, (3-aminopropyl)dibutyl propoxy silane, (3-aminopropyl)dimethyl butoxy silane, (3-aminopropyl)diethyl butoxy silane, (3-aminopropyl)dipropyl butoxy silane, and (3-aminopropyl)dibutyl butoxy silane; [(methyl amino)propyl] trialkoxy silanes, such as [3-(methyl amino)propyl] trimethoxy silane, [3-(methyl amino)propyl] triethoxy silane, [3 - (methyl amino) propyl] tripropoxy silane, and [3-(methyl amino)propyl] tributoxy silane; [(methyl amino)propyl] alkyl dialkoxy silanes, such as [3-(methyl amino)propyl] methyl dimethoxy silane, [3-(methyl amino)propyl] ethyl dimethoxy silane, [3-(methyl amino)propyl] propyl dimethoxy silane, [3-(methyl amino)propyl] butyl dimethoxy silane, [3-(methyl amino)propyl] methyl diethoxy silane, [3-(methyl amino)propyl] ethyl diethoxy silane, [3-(methyl amino)propyl] propyl diethoxy silane, [3-(methyl amino)propyl] butyl diethoxy silane, [3-(methyl amino)propyl] methyl dipropoxy silane, [3-(methyl amino)propyl] ethyl dipropoxy silane, [3-(methyl amino)propyl] propyl dipropoxy silane, [3-(methyl amino)propyl] butyl dipropoxy silane, [3-(methyl amino)propyl] methyl dibutoxy silane, [3-(methyl amino)propyl] ethyl dibutoxy silane, [3-(methyl amino)propyl] propyl dibutoxy silane, and [3-(methyl amino)propyl] butyl dibutoxy silane; [(methyl amino) propyl] dialkyl alkoxy silanes, such as [3-(methyl amino)propyl] dimethyl methoxy silane, [3-(methyl amino)propyl] diethyl methoxy silane, [3-(methyl amino)propyl] dipropyl methoxy silane, [3-(methyl amino)propyl] dibutyl methoxy silane, [3- (methyl amino)propyl] dimethyl ethoxy silane, [3- (methyl amino)propyl] diethyl ethoxy silane, [3-(methyl amino)propyl] dipropyl ethoxy silane, [3-(methyl amino)propyl] dibutyl ethoxy silane, [3-(methyl amino)propyl] dimethyl propoxy silane, [3-(methyl amino)propyl] diethyl propoxy silane, [3-(methyl amino)propyl] dipropyl propoxy silane, [3-(methyl amino)propyl] dibutyl propoxy silane, [3-(methyl amino)propyl] dimethyl butoxy silane, [3-(methyl amino)propyl] diethyl butoxy silane, [3-(methyl amino)propyl] dipropyl butoxy silane, and [3-(methyl amino)propyl] dibutyl butoxy silane; [(dimethyl amino)propyl] trialkoxy silanes, such as [3-(dimethyl amino) propyl] trimethoxy silane, [3 - (dimethyl amino) propyl] triethoxy silane, [3-(dimethyl amino)propyl] tripropoxy silane, and [3-(dimethyl amino)propyl] tributoxy silane; [(dimethyl amino)propyl] alkyl dialkoxy silanes, such as [3-(dimethyl amino)propyl] methyl dimethoxy silane, [3-(dimethyl amino)propyl] ethyl dimethoxy silane, [3-(dimethyl amino)propyl] propyl dimethoxy silane, [3-(dimethyl amino)propyl] butyl dimethoxy silane, [3-(dimethyl amino)propyl] methyl diethoxy silane, [3-(dimethyl amino)propyl] ethyl diethoxy silane, [3-(dimethyl amino)propyl] propyl diethoxy silane, [3-(dimethyl amino)propyl] butyl diethoxy silane, [3-(dimethyl amino)propyl] methyl dipropoxy silane, [3-(dimethyl amino)propyl] ethyl dipropoxy silane, [3-(dimethyl amino)propyl] propyl dipropoxy silane, [3-(dimethyl amino)propyl] butyl dipropoxy silane, [3-(dimethyl amino)propyl] methyl dibutoxy silane, [3-(dimethyl amino)propyl] ethyl dibutoxy silane, [3-(dimethyl amino)propyl] propyl dibutoxy silane, and [3 - (dimethyl amino) propyl] butyl dibutoxy silane ; [(dimethyl amino)propyl] dialkyl alkoxy silanes, such as [3-(dimethyl amino)propyl] dimethyl methoxy silane, [3-(dimethyl amino)propyl] diethyl methoxy silane, [3-(dimethyl amino)propyl] dipropyl methoxy silane, [3-(dimethyl amino)propyl] dibutyl methoxy silane, [3-(dimethyl amino)propyl] dimethyl ethoxy silane, [3-(dimethyl amino)propyl] diethyl ethoxy silane, [3-(dimethyl amino)propyl] dipropyl ethoxy silane, [3-(dimethyl amino)propyl] dibutyl ethoxy silane, [3-(dimethyl amino)propyl] dimethyl propoxy silane, [3-(dimethyl amino)propyl] diethyl propoxy silane, [3-(dimethyl amino)propyl] dipropyl propoxy silane, [3-(dimethyl amino)propyl] dibutyl propoxy silane, [3-(dimethyl amino)propyl] dimethyl butoxy silane, [3-(dimethyl amino)propyl] diethyl butoxy silane, [3-(dimethyl amino)propyl] dipropyl butoxy silane, and [3-(dimethyl amino)propyl] dibutyl butoxy silane; [(trialkoxysilyl)propyl] trimethyl ammoniums, such as [3-(trimethoxysilyl)propyl] trimethyl ammonium, [3-(triethoxysilyl)propyl] trimethyl ammonium, [3-(tripropoxysilyl)propyl] trimethyl ammonium, and [3-(tributoxysilyl)propyl] trimethyl ammonium; [(alkyl dialkoxy silyl)propyl[trimethyl ammoniums, such as [3-(methyl dimethoxy silyl)propyl] trimethyl ammonium, [3-(ethyl dimethoxy silyl)propyl] trimethyl ammonium, [3-(propyl dimethoxy silyl)propyl] trimethyl ammonium, [3-(butyl dimethoxy silyl)propyl] trimethyl ammonium, [3-(methyl diethoxy silyl)propyl] trimethyl ammonium, [3-(ethyl diethoxy silyl)propyl] trimethyl ammonium, [3-(propyl diethoxy silyl)propyl] trimethyl ammonium, [3-(butyl diethoxy silyl)propyl] trimethyl ammonium, [3-(methyl dipropoxy silyl)propyl] trimethyl ammonium, [3-(ethyl dipropoxy silyl)propyl] trimethyl ammonium, [3-(propyl dipropoxy silyl)propyl] trimethyl ammonium, [3-(butyl dipropoxy silyl)propyl] trimethyl ammonium, [3-(methyl dibutoxy silyl)propyl] trimethyl ammonium, [3-(ethyl dibutoxy silyl)propyl] trimethyl ammonium, [3-(propyl dibutoxy silyl)propyl] trimethyl ammonium, and [3-(butyl dibutoxy silyl)propyl] trimethyl ammonium; [(dialkyl alkoxy silyl)propyl] trimethyl ammoniums, such as [3-(dimethyl methoxy silyl)propyl] trimethyl ammonium, [3-(diethyl methoxy silyl)propyl] trimethyl ammonium, [3-(dipropyl methoxy silyl)propyl] trimethyl ammonium, [3-(dibutyl methoxy silyl)propyl] trimethyl ammonium, [3-(dimethyl ethoxy silyl)propyl] trimethyl ammonium, [3-(diethyl ethoxy silyl)propyl] trimethyl ammonium, [3-(dipropyl ethoxy silyl)propyl] trimethyl ammonium, [3-[dibutyl ethoxy silyl)propyl] trimethyl ammonium, [3-(dimethyl propoxy silyl)propyl] trimethyl ammonium, [3-(diethyl propoxy silyl)propyl] trimethyl ammonium, [3-(dipropyl propoxy silyl)propyl] trimethyl ammonium, [3-(dibutyl propoxy silyl)propyl] trimethyl ammonium, [3-(dimethyl butoxy silyl)propyl] trimethyl ammonium, [3-(diethyl butoxy silyl)propyl] trimethyl ammonium, [3-(dipropyl butoxy silyl)propyl] trimethyl ammonium, and [3-(dibutyl butoxy silyl)propyl] trimethyl ammonium; (3-aminopropyl)trihalosilanes, such as (3-aminopropyl)trichlorosilane and (3-aminopropyl)tribromosilane; [(aminoalkyl amino)propyl] trialkoxy silanes, such as [3-(2-aminoethyl amino)propyl]trimethoxy silane and [3-(6-aminohexyl amino)propyl] trimethoxy silane; [(aminoalkyl amino) propyl] alkyl dialkoxy silanes, such as [3-(2-aminoethyl amino)propyl] methyl dimethoxy silane and [3-(6-aminohexyl amino)propyl] methyl dimethoxy silane; and [(aminoalkyl amino)propyl] dialkyl alkoxy silanes, such as [3-(2-aminoethyl amino)propyl] dimethyl methoxy silane and [3-(6-aminohexyl amino)propyl] dimethyl methoxy silane.

Among these silane coupling agents having amino groups, (3-aminopropyl)triethoxy silane, (3-aminopropyl)ethyl diethoxy silane, and (3-aminopropyl)diethyl ethoxy silane are preferred from a viewpoint of reactivity with the raw material silica and stability.

In addition, a silane coupling agent having a halogeno group is not particularly limited. Specific examples of silane coupling agent having a chloro group include, for example, (chloropropyl)trialkoxy silanes, such as (3-chloropropyl)trimethoxy silane, (3-chloropropyl)triethoxy silane, (3-chloropropyl)tripropoxy silane, and (3-chloropropyl)tributoxy silane; (chloropropyl)alkyl dialkoxy silanes, such as (3-chloropropyl)methyl dimethoxy silane, (3-chloropropyl)methyl diethoxy silane, (3-chloropropyl)methyl dipropoxy silane, (3-chloropropyl)methyl dibutoxy silane, (3-chloropropyl)ethyl dimethoxy silane, (3-chloropropyl)ethyl diethoxy silane, (3-chloropropyl)ethyl dipropoxy silane, (3-chloropropyl)ethyl dibutoxy silane, (3-chloropropyl)propyl dimethoxy silane, (3-chloropropyl)propyl diethoxy silane, (3-chloropropyl)propyl dipropoxy silane, (3-chloropropyl)propyl dibutoxy silane, (3-chloropropyl)butyl dimethoxy silane, (3-chloropropyl)butyl diethoxy silane, (3-chloropropyl)butyl dipropoxy silane, and (3-chloropropyl)butyl dibutoxy silane; (chloropropyl)dialkyl alkoxy silanes, such as (3-chloropropyl)dimethyl methoxy silane, (3-chloropropyl)diethyl methoxy silane, (3-chloropropyl)dipropyl methoxy silane, (3-chloropropyl)dibutyl methoxy silane, (3-chloropropyl)dimethyl ethoxy silane, (3-chloropropyl)diethyl ethoxy silane, (3-chloropropyl)dipropyl ethoxy silane, (3-chloropropyl)dibutyl ethoxy silane, (3-chloropropyl)dimethyl propoxy silane, (3-chloropropyl)diethyl propoxy silane, (3-chloropropyl)dipropyl propoxy silane, (3-chloropropyl)dibutyl propoxy silane, (3-chloropropyl)dimethyl butoxy silane, (3-chloropropyl)diethyl butoxy silane, (3-chloropropyl)dipropyl butoxy silane, and (3-chloropropyl)dibutyl butoxy silane; (3-chloropropyl)trihalosilanes, such as (3-chloropropyl)trichlorosilane and (3-chloropropyl)tribromosilane; (chlorophenyl)trialkoxy silanes, such as (3-chlorophenyl)trimethoxy silane, (4-chlorophenyl)trimethoxy silane, (3-chlorophenyl)triethoxy silane, (4-chlorophenyl)triethoxy silane, (3-chlorophenyl)tripropoxy silane, (4-chlorophenyl)tripropoxy silane, (3-chlorophenyl)tributoxy silane, and (4-chlorophenyl)tributoxy silane; (chlorophenyl) alkyl dialkoxy silanes, such as (3-chlorophenyl)methyl dimethoxy silane, (4-chlorophenyl)methyl dimethoxy silane, (3-chlorophenyl)methyl diethoxy silane, (4-chlorophenyl)methyl diethoxy silane, (3-chlorophenyl)methyl dipropoxy silane, (4-chlorophenyl)methyl dipropoxy silane, (3-chlorophenyl)methyl dibutoxy silane, (4-chlorophenyl)methyl dibutoxy silane, (3-chlorophenyl)ethyl dimethoxy silane, (4-chlorophenyl)ethyl dimethoxy silane, (3-chlorophenyl)ethyl diethoxy silane, (4-chlorophenyl)ethyl diethoxy silane, (3-chlorophenyl)ethyl dipropoxy silane, (4-chlorophenyl)ethyl dipropoxy silane, (3-chlorophenyl)ethyl dibutoxy silane, (4-chlorophenyl)ethyl dibutoxy silane, (3-chlorophenyl)propyl dimethoxy silane, (4-chlorophenyl)propyl dimethoxy silane, (3-chlorophenyl)propyl diethoxy silane, (4-chlorophenyl)propyl diethoxy silane, (3-chlorophenyl)propyl dipropoxy silane, (4-chlorophenyl)propyl dipropoxy silane, (3-chlorophenyl)propyl dibutoxy silane, (4-chlorophenyl)propyl dibutoxy silane, (3-chlorophenyl)butyl dimethoxy silane, (4-chlorophenyl)butyl dimethoxy silane, (3-chlorophenyl)butyl diethoxy silane, (4-chlorophenyl)butyl diethoxy silane, (3-chlorophenyl)butyl dipropoxy silane, (4-chlorophenyl)butyl dipropoxy silane, (3-chlorophenyl)butyl dibutoxy silane, and (4-chlorophenyl)butyl dibutoxy silane; (chlorophenyl) dialkyl alkoxy silanes, such as (3-chlorophenyl)dimethyl methoxy silane, (4-chlorophenyl)dimethyl methoxy silane, (3-chlorophenyl)diethyl methoxy silane, (4-chlorophenyl)diethyl methoxy silane, (3-chlorophenyl)dipropyl methoxy silane, (4-chlorophenyl)dipropyl methoxy silane, (3-chlorophenyl)dibutyl methoxy silane, (4-chlorophenyl)dibutyl methoxy silane, (3-chlorophenyl)dimethyl ethoxy silane, (4-chlorophenyl)dimethyl ethoxy silane, (3-chlorophenyl)diethyl ethoxy silane, (4-chlorophenyl)diethyl ethoxy silane, (3-chlorophenyl)dipropyl ethoxy silane, (4-chlorophenyl)dipropyl ethoxy silane, (3-chlorophenyl)dibutyl ethoxy silane, (4-chlorophenyl)dibutyl ethoxy silane, (3-chlorophenyl)dimethyl propoxy silane, (4-chlorophenyl)dimethyl propoxy silane, (3-chlorophenyl)diethyl propoxy silane, (4-chlorophenyl)diethyl propoxy silane, (3-chlorophenyl)dipropyl propoxy silane, (4-chlorophenyl)dipropyl propoxy silane, (3-chlorophenyl)dibutyl propoxy silane, (4-chlorophenyl)dibutyl propoxy silane, (3-chlorophenyl)dimethyl butoxy silane, (4-chlorophenyl)dimethyl butoxy silane, (3-chlorophenyl)diethyl butoxy silane, (4-chlorophenyl)diethyl butoxy silane, (3-chlorophenyl)dipropyl butoxy silane, (4-chlorophenyl)dipropyl butoxy silane, (3-chlorophenyl)dibutyl butoxy silane, and (4-chlorophenyl)dibutyl butoxy silane; and (chlorophenyl)trihalosilanes, such as (3-chlorophenyl)trichlorosilane, (4-chlorophenyl)trichlorosilane, (3-chlorophenyl)tribromosilane, and (4-chlorophenyl)tribromosilane.

Specific examples of the silane coupling agent having a bromo group include, for example, (bromopropyl)trialkoxy silanes, such as (3-bromopropyl)trimethoxy silane, (3-bromopropyl)triethoxy silane, (3-bromopropyl)tripropoxy silane, and (3-bromopropyl)tributoxy silane; (bromopropyl)alkyl dialkoxy silanes, such as (3-bromopropyl)methyl dimethoxy silane, (3-bromopropyl)methyl diethoxy silane, (3-bromopropyl)methyl dipropoxy silane, (3-bromopropyl)methyl dibutoxy silane, (3-bromopropyl)ethyl dimethoxy silane, (3-bromopropyl)ethyl diethoxy silane, (3-bromopropyl)ethyl dipropoxy silane, (3-bromopropyl)ethyl dibutoxy silane, (3-bromopropyl)propyl dimethoxy silane, (3-bromopropyl)propyl diethoxy silane, (3-bromopropyl)propyl dipropoxy silane, (3-bromopropyl)propyl dibutoxy silane, (3-bromopropyl)butyl dimethoxy silane, (3-bromopropyl)butyl diethoxy silane, (3-bromopropyl)butyl dipropoxy silane, and (3-bromopropyl)butyl dibutoxy silane; (bromopropyl)dialkyl alkoxy silanes, such as (3-bromopropyl)dimethyl methoxy silane, (3-bromopropyl)diethyl methoxy silane, (3-bromopropyl)dipropyl methoxy silane, (3-bromopropyl)dibutyl methoxy silane, (3-bromopropyl)dimethyl ethoxy silane, (3-bromopropyl)diethyl ethoxy silane, (3-bromopropyl)dipropyl ethoxy silane, (3-bromopropyl)dibutyl ethoxy silane, (3-bromopropyl)dimethyl propoxy silane, (3-bromopropyl)diethyl propoxy silane, (3-bromopropyl)dipropyl propoxy silane, (3-bromopropyl)dibutyl propoxy silane, (3-bromopropyl)dimethyl butoxy silane, (3-bromopropyl)diethyl butoxy silane, (3-bromopropyl)dipropyl butoxy silane, and (3-bromopropyl)dibutyl butoxy silane; (bromopropyl)trihalosilanes, such as (3-bromopropyl)trichlorosilane and (3-bromopropyl)tribromosilane; (bromophenyl)trialkoxy silanes, such as (3-bromophenyl)trimethoxy silane, (4-bromophenyl)trimethoxy silane, (3-bromophenyl)triethoxy silane, (4-bromophenyl)triethoxy silane, (3-bromophenyl)tripropoxy silane, (4-bromophenyl)tripropoxysilane, (3-bromophenyl)tributoxy silane, and (4-bromophenyl)tributoxy silane; (bromophenyl) alkyl dialkoxy silanes, such as (3-bromophenyl)methyl dimethoxy silane, (4-bromophenyl)methyl dimethoxy silane, (3-bromophenyl)methyl diethoxy silane, (4-bromophenyl)methyl diethoxy silane, (3-bromophenyl)methyl dipropoxy silane, (4-bromophenyl)methyl dipropoxy silane, (3-bromophenyl)methyl dibutoxy silane, (4-bromophenyl)methyl dibutoxy silane, (3-bromophenyl)ethyl dimethoxy silane, (4-bromophenyl)ethyl dimethoxy silane, (3-bromophenyl)ethyl diethoxy silane, (4-bromophenyl)ethyl diethoxy silane, (3-bromophenyl)ethyl dipropoxy silane, (4-bromophenyl)ethyl dipropoxy silane, (3-bromophenyl)ethyl dibutoxy silane, (4-bromophenyl)ethyl dibutoxy silane, (3-bromophenyl)propyl dimethoxy silane, (4-bromophenyl)propyl dimethoxy silane, (3-bromophenyl)propyl diethoxy silane, (4-bromophenyl)propyl diethoxy silane, (3-bromophenyl)propyl dipropoxy silane, (4-bromophenyl)propyl dipropoxy silane, (3-bromophenyl)propyl dibutoxy silane, (4-bromophenyl)propyl dibutoxy silane, (3-bromophenyl)butyl dimethoxy silane, (4-bromophenyl)butyl dimethoxy silane, (3-bromophenyl)butyl diethoxy silane, (4-bromophenyl)butyl diethoxy silane, (3-bromophenyl)butyl dipropoxy silane, (4-bromophenyl)butyl dipropoxy silane, (3-bromophenyl)butyl dibutoxy silane, and (4-bromophenyl) butyl dibutoxy silane; (bromophenyl) dialkyl alkoxy silanes, such as (3-bromophenyl)dimethyl methoxy silane, (4-bromophenyl)dimethyl methoxy silane, (3-bromophenyl)dimethyl ethoxy silane, (4-bromophenyl)dimethyl ethoxy silane, (3-bromophenyl)dimethyl propoxy silane, (4-bromophenyl)dimethyl propoxy silane, (3-bromophenyl)dimethyl butoxy silane, (4-bromophenyl)dimethyl butoxy silane, (3-bromophenyl)diethyl methoxy silane, (4-bromophenyl)diethyl methoxy silane, (3-bromophenyl)diethyl ethoxy silane, (4-bromophenyl)diethyl ethoxy silane, (3-bromophenyl)diethyl propoxy silane, (4-bromophenyl)diethyl propoxy silane, (3-bromophenyl)diethyl butoxy silane, (4-bromophenyl)diethyl butoxy silane, (3-bromophenyl)dipropyl methoxy silane, (4-bromophenyl)dipropyl methoxy silane, (3-bromophenyl)dipropyl ethoxy silane, (4-bromophenyl)dipropyl ethoxy silane, (3-bromophenyl)dipropyl propoxy silane, (4-bromophenyl)dipropyl propoxy silane, (3-bromophenyl)dipropyl butoxy silane, (4-bromophenyl)dipropyl butoxy silane, (3-bromophenyl)dibutyl methoxy silane, (4-bromophenyl)dibutyl methoxy silane, (3-bromophenyl)dibutyl ethoxy silane, (4-bromophenyl)dibutyl ethoxy silane, (3-bromophenyl)dibutyl propoxy silane, (4-bromophenyl)dibutyl propoxy silane, (3-bromophenyl)dibutyl butoxy silane, and (4-bromophenyl)dibutyl butoxy silane; and (bromophenyl)trihalosilanes, such as (3-bromophenyl)trichlorosilane, (4-bromophenyl)trichlorosilane, (3-bromophenyl)tribromosilane, and (4-bromophenyl)tribromosilane.

In a silane coupling agent having a fluoro or iodo group, a silane coupling agent in which a chlorine or bromine atom in any of the compounds listed above as specific examples of the silane coupling agent having a chloro or bromo group is substituted with a fluorine or iodine atom respectively can be used.

Among these silane coupling agents having halogeno groups, (3-chloropropyl)trimethoxy silane, (3-chloropropyl)triethoxy silane, (3-bromopropyl)trimethoxy silane, and (3-bromopropyl)triethoxy silane are preferred from a viewpoint of reactivity with the raw material silica and stability.

The silane coupling agents described above may be used alone or in combination of two or more thereof.

A synthetic product or a commercial product may be used as the silane coupling agents described. For example, a method for synthesizing a silane coupling agent having an amino group is not particularly limited, and examples thereof include a known method in which, for example, a halogen-containing silane compound, such as (3-bromopropyl)trimethoxy silane , and a compound having an amino group described above are reacted together in a solvent, such as toluene and xylene, in the presence of an acid catalyst, such as sulfuric acid.

The solvent used for synthesis reaction between a raw material silica and a silane coupling agent is not particularly limited, and examples thereof include, for example, water, and organic solvents including lower alcohols such as methanol, ethanol, n-propanol, and isopropyl alcohol; ketones such as acetone and methyl ethyl ketone; ethers such as diethyl ether, dioxane, and tetrahydrofuran; amides such as N,N-dimethylformamide; sulfoxides such as dimethyl sulfoxide; and the like. Among these, organic solvents are preferred. These solvents may be used individually or as a mixture of two or more thereof.

For example, when a silane coupling agent is added to a colloidal silica dispersed in water, a hydrophilic solvent is preferably added in an amount such that the silane coupling agent can dissolve. Examples of the hydrophilic organic solvent include, for example, alcohols such as methanol, ethanol, and isopropyl alcohol. Among these, the same alcohol as an alcohol generated by hydrolysis of the silane coupling agent is preferably used. This is because use of the same alcohol as an alcohol generated by hydrolysis of the silane coupling agent permits the solvent to be more easily collected and reused.

A lower limit of the amount of the silane coupling agent used during the synthesis reaction is preferably 0.1 mol% or more, more preferably 1 mol% or more, and still more preferably 10 mol% or more when the number of moles of the silica contained (the number of moles obtained by counting $SiO_2$ as one molecule) is 100 mol%. An upper limit of the amount of the silane coupling agent used during the synthesis reaction is preferably 90 mol% or less, more preferably 85 mol% or less, and still more preferably 80 mol% or less when the number of moles of the raw material silica is 100 mol%. Within these ranges, the zeta potential is sufficiently stable in an acidic condition, and the raw material silica can be prevented from gelling over time.

When a colloid-state silica, such as colloidal silica, is used as a raw material, it can be formed by adding 5 mmol of a silane coupling agent to 195 g of silica. The amount of a silane coupling agent added is preferably 3 mmol to 15 mmol relative to 195 g of silica.

The atmosphere to be used during the synthesis reaction is not particularly limited. The synthesis reaction may be carried out in an air atmosphere, in an inert gas atmosphere, such as nitrogen or argon, or under vacuum.

The pH during the synthesis reaction is not particularly limited either. However, pH in a range from 7 to 11 is preferred. Within this range, the silane coupling agent reacts efficiently with the raw material silica, and possibility of self-condensation of the silane coupling agent can thus be reduced.

A lower limit of reaction temperature is not particularly limited, but is preferably 5°C or higher, more preferably 7°C or higher, and still more preferably 10°C or higher. In addition, an upper limit of reaction temperature is not particularly limited, but is preferably 100°C or lower, more preferably 95°C or lower, and still more preferably 90°C or lower. Within this range, the silane coupling agent can react efficiently with the raw material silica.

A lower limit of the reaction time is not particularly limited, but is preferably 1 hour or longer, more preferably 2 hours or longer, and still more preferably 3 hours or longer. Within this range, the silane coupling agent can react efficiently with the raw material silica. Note that an upper limit of reaction time is not particularly limited either, but is usually 24 hours or shorter from a viewpoint of workability.

The synthesis reaction may be carried out in a single stage or in two stages by changing a reaction temperature.

After the reaction is complete, the reaction solvent is removed by distillation under reduced pressure using, for example, a rotary evaporator, and thus the intended silica in which a specific functional group is fixed on a surface thereof can be obtained.

The content of silica contained in the polishing composition is not particularly limited, but is preferably 0.05 mass% or more, more preferably 0.1 mass% or more, and still more preferably 0.5 mass% or more. There is an advantage of improving the polishing rate of polishing object by the polishing composition as the content of silica is increased.

The content of silica contained in the polishing composition is not particularly limited, but is preferably 50 mass% or less, more preferably 25 mass% or less, and still more preferably 20 mass% or less. The manufacturing cost can be reduced as the content of silica is decreased.

[pH-Adjusting Agent]

A polishing composition of the present invention contains a pH-adjusting agent for adjusting pH to a desired value. Examples of the pH-adjusting agent include acids and alkalis as listed below.

In a polishing composition of the present invention, a pH-adjusting agent may be either an acid or an alkali, and may be either an inorganic or organic compound. Specific examples of the acid include, for example, inorganic acids, such as sulfuric acid, nitric acid, boric acid, carbonic acid, hypophosphorous acid, hypophosphoric acid, and phosphoric acid; organic acids including carboxylic acids, such as formic acid, acetic acid, propionic acid, butyric acid, valeric acid, 2-methyl butanoic acid, n-hexanoic acid, 3,3-dimethyl butanoic acid, 2-ethyl butanoic acid, 4-methyl pentanoic acid, n-heptanoic acid, 2-methyl hexanoic acid, n-octanoic acid, 2-ethyl hexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid, organic sulfonic acids, such as methanesulfonic acid, ethanesulfonic acid, and isethionic acid; and the like. Specific examples of the alkali include amines, such as ammonia, ethylenediamine, and piperazine; quaternary ammonium salts, such astetramethylammonium and tetraethylammonium;and metal hydroxides, such as potassium hydroxide and sodium hydroxide. These pH-adjusting agents may be used individually or as a mixture of two or more thereof.

Among these pH-adjusting agents, from a viewpoint of stability of the composition, inorganic acids or metal hydroxides are preferred, and nitric acid, sulfuric acid, and potassium hydroxide are more preferred.

The pH of a polishing composition of the present invention is preferably 0.5 or more, more preferably 1 or more, and still more preferably 2 or more. There is an advantage of easily handling as the pH is increased.

The pH of the polishing composition of the present invention is preferably 12 or less, more preferably 11.5 or less, and still more preferably 11 or less. There is an advantage of preventing dissolution of silica as the pH is decreased.

The content of the pH-adjusting agent in a polishing composition is not particularly limited, and may be selected as appropriate so that the pH value falls within the range described above.

[Dispersion Medium or Solvent]

A polishing composition of the present invention may contain a dispersion medium or a solvent. Possible examples of the dispersion medium or solvent include an organic solvent and water, among which water is preferably contained. From a viewpoint of inhibition of any action of other components, water preferably contains as little impurities as possible. More specifically, pure or ultrapure water obtained by removing impurities by ion-exchange resin before being filtered to remove foreign matter, or distilled water, is preferred.

[Other Components]

A polishing composition of the present invention may further contain other components as needed, such as abrasive grain other than the silica in which a specific functional group is fixed on a surface thereof described above (hereinafter also referred to as "other abrasive grain"), complexing agent, metallic corrosion inhibitor, preservative, antifungalagent, oxidizingagent, reducingagent, surfactant. A description will now be provided regarding other abrasive grain, an oxidizing agent, a preservative, and an antifugal agent.

(Other Abrasive Grain)

The abrasive grain other than the silica described above may be any of an inorganic particle, an organic particle, and an organic-inorganic hybrid particle. Specific examples of the inorganic particle include, for example, particles containing metal oxides such as silica (except the silica in which a specific functional group is fixed on a surface thereof described above), alumina, ceria, and titania, a silicon nitride particle, a silicon carbide particle, and a boron nitride particle. Specific examples of the organic particle include, for example, a polymethyl methacrylate (PMMA) particle. "Other abrasive grains" may be used individually or as a mixture of two or more thereof. In addition, "other abrasive grain" may be a commercially available product or a synthetic product.

(Oxidizing Agent)

An oxidizing agent oxidizes a surface of the polishing obj ect, and thus increases the polishing rate of the polishing object with the polishing composition.

Examples of the oxidizing agent include, for example, peroxides. Specific examples of the peroxide include hydrogen peroxide, peracetic acid, percarbonate, urea peroxide, perhalogen acids such as perchloric acid and periodic acid, and persulfates such as sodium persulfate, potassium persulfate, and ammonium persulfate. These oxidizing agents may be used individually or as a mixture of two or more thereof. Among these, from a viewpoint of reactivity with a surface of the polishing obj ect, persulfates and hydrogen peroxide are preferred, and hydrogen peroxide is particularly preferred.

The content of the oxidizing agent in the polishing composition is preferably 0.01 mass% or more, more preferably 0.1 mass% or more, and still more preferably 0.3 mass% or more. The polishing rate of the polishing object is further improved as the content of oxidizing agent is increased.

In addition, the content of the oxidizing agent in the polishing composition is preferably 20 mass% or less, more preferably 10 mass% or less, and still more preferably 4 mass% or less. As the content of oxidizing agent is decreased, the material cost of the polishing composition can be reduced, and the burden for deposing of the polishing composition after use in polishing, i.e., the burden for deposing of liquid waste can be alleviated as well. Moreover, the possibility of excessive oxidation, by the oxidizing agent, of a surface of the polishing object can be reduced.

(Preservative or Antifugal Agent)

Examples of the preservative or antifugal agent include, for example, isothiazoline-based preservatives, such as 2-methyl-4-isothiazolin-3-one and 5-chloro-2-methyl-4-isothiazolin-3-one, para-hydroxybenzoates, phenoxyethanol, and the like. These preservatives or antifugal agents may be used individually or as a mixture of two or more thereof.

A polishing composition of the present invention may be a one-component type, or a multi-component type including a two-component type. In addition, a polishing composition of the present invention may be prepared and used by diluting a concentrate of the polishing composition, for example, ten or more times with a diluent such as water.

<Method for Producing Polishing Composition>

The method for producing a polishing composition of the present invention is not particularly limited. A polishing composition of the present invention may be obtained by, for example, stirring and mixing the silica in which a specific functional group is fixed on a surface thereof, and a pH-adjusting agent, as well as other components as needed. That is, a method for producing a polishing composition according to another embodiment of the present invention includes mixing together a silica in which a functional group satisfying at least one of condition (1) and condition (2) listed below is fixed on a surface thereof, and a pH-adjusting agent; condition (1) : the functional group has an amino group; and condition (2) : the functional group has a halogeno group.

The temperature during mixture of the components is not particularly limited, but a temperature in a range from 10°C to 40°C is preferred, and heating may be used to increase the dissolution rate.

<Use of Polishing Composition>

A polishing composition of the present invention is suitable for polishing a polishing object having a layer containing a Si-containing material. Examples of the Si-containing material include monocrystalline silicon, polycrystalline silicon (poly-Si), silicon oxide, and silicon nitride. In particular, from a viewpoint of efficiently achieving advantageous effects of the present invention, such a Si-containing material preferably contains polycrystalline silicon or silicon nitride, more preferably silicon nitride, and still more preferably both polycrystalline silicon and silicon nitride.

When condition (1) (i.e., the functional group has an amino group) is satisfied, a polishing composition of the present invention is suitable for polishing a polishing object having a layer containing a noble metal. Examples of the noble metal include gold (Au), silver (Ag), platinum (Pt), palladium (Pd), rhodium (Rh), ruthenium (Ru), iridium (Ir), and osmium (Os) . Among these, ruthenium (includingrutheniumasasingle material, ruthenium alloys, and ruthenium compounds), which has not yet been capable of achieving a high polishing rate, is preferred.

Today, damascene wiring in a high-performance logic device primarily uses copper as the wiring metal. For preventing the copper from diffusing into an interlayer insulation film, a barrier layer containing tantalum, a tantalum alloy, or a tantalum compound is often formed under wiring made of copper, a copper alloy, or other material. Meanwhile, in recent years, studies have been conducted on ruthenium, a ruthenium alloy, or a ruthenium compound as a material of such a barrier layer. Ruthenium, a ruthenium alloy, or a ruthenium compound has a lower resistivity than tantalum, a tantalum alloy, or a tantalum compound, and therefore provides an advantage in that a chemical vapor deposition (CVD) technique can be used for forming a film, and that a smaller wire width is thus achievable. However, a problem exists in that polishing ruthenium, a ruthenium alloy, or a ruthenium compound is difficult due to higher chemical stability and higher hardness than other damascene wiring metal films such as one containing copper. For example, the composition for polishing a ruthenium film disclosed in JP 2008-034818 A has not yet achieved a sufficiently high polishing rate.

A detailed reason why use of a polishing composition of the present invention can achieve a high polishing rate in polishing ruthenium, ruthenium alloys, and ruthenium compounds is yet unknown. Such an effect appears to be due presumably to the following mechanism. Note that the present invention is by no means limited to the mechanism described below.

It is speculated that fixedly locating, on a silica surface, a functional group having an amino group results in a nucleophilic addition reaction between ruthenium, which is the polishing object, and the amino group, and thus causes ruthenium and the amino group to be bonded to each other; this, then, weakens metallic bonds between ruthenium atoms, thereby making the bonds easy to break; and thus the polishing rate improves.

A polishing composition of the present invention may be used for polishing an object other than the material to be polished including the polishing object described above. Examples of the material to be polished include inorganic insulation layers, such as glass formed on a substrate; layers primarily containing Al, Cu, Ti, W, Ta, etc.; optical glass, such as photomasks, lenses, prisms; inorganic electroconductive layers, such as ITO; optical integrated circuits, optical switching devices, and optical waveguides formed with glass and crystalline material; an end face of an optical fiber; optical single crystals, such as scintillator; solid-state laser single crystals; a sapphire substrate for blue laser LED; semiconductor single crystals, such as GaP and GaAs; a glass substrate for magnetic disk; a magnetic head, and the like.

<Polishing Method, Method for Producing Substrate>

In one aspect of the present invention, there is provided a polishing method including a step of polishing a material to be polished including a polishing obj ect using the polishing composition described above. Moreover, in another aspect of the present invention, there is provided a method for producing a substrate including a step of polishing using the polishing method described above.

Polishing of a material to be polished using a polishing composition of the present invention can be carried out with an apparatus and/or under conditions for use in usual metal polishing. There is a one-side or both-side polishing apparatus as a typical polishing apparatus. A one-side polishing apparatus holds the substrate using a holder called carrier, and presses and rotates a surface plate having a polishing pad adhered on a facing surface of the substrate, with the polishing composition being fed from above, thus to polish one side of the material to be polished. Polishing is performed, during this process, by a physical action caused by friction between both the polishing pad and the polishing composition, and the material to be polished, as well as a chemical action exerted on the material to be polished with the polishing composition. Porous materials, such as unwoven fabric, polyurethane, and suede may be used as the polishing pad without specific limitation. The polishing pad is preferably processed for collecting the polishing solution.

The conditions of the polishing method of the present invention include a polishing load, a rotational speed of the surface plate, a rotational speed of the carrier, a flow rate of the polishing composition, and polishing time. These conditions are not particularly limited, but, for example, the polishing load is preferably in a range from 0.1 psi or more to 10 psi or less, more preferably in a range from 0.5 or more psi to 8.0 psi or less, and still more preferably in a range from 1.0 psi or more to 6.0 psi or less, per unit area of the substrate (in this connection, conversion uses a relationship of 1 psi = 6894.757 Pa). The higher a load is, the higher a force of friction is; therefore, since a mechanical working force is improved, the polishing rate is increased. Within this range, a sufficiently high polishing rate is achieved, and thus damage of the substrate due to the load, and/or occurrence of defect such as flow on a surface of the substrate, can be prevented. The rotational speed of the surface plate and the rotational speed of the carrier are each preferably in a range from 10 to 500 rpm. The feed rate of the polishing composition needs only to suffice to cover the entire substrate of the material to be polished, and may be adjusted depending on conditions such as the size of the substrate.

Examples

The present invention will be described in more detail using Examples and Comparative Examples presented below. However, the technological scope of the present invention is not limited to Examples presented below only.

[Examples 1 to 5 and Comparative Examples 1 to 3]

(Synthesis of Silica in Which Functional Group Having Amino Group Is Fixed on Surface (Silica A))

As a raw material silica, 1000 g of colloidal silica solution (concentration: 19.5mass%, average primary particle size: 35 nm, average secondary particle size: 68 nm) was prepared. In addition, 5 mmol (1.12 g) of (3-aminopropyl) triethoxy silane, which was a silane coupling agent, was weighed out and dissolved in 50 g of methanol.

While the colloidal silica solution was being stirred at a rotational speed of stirring blade of 600 rpm at 25°C in an air atmosphere, the methanol solution of silane coupling agent mentioned above was dropped at a rate of 1 mL/min. After dropping, pH was adjusted using a pH-adjusting agent (KOH) so that the pH of the solution falls within a range from 8.0 to 9.0.

After the pH adjustment, the solution was left to stand for 8 hours in an air bath at 40°C, and was then left to stand for 12 hours in an air bath at 60°C. Thereafter, methanol was removed using a rotary evaporator to obtain silica A.

Performing XPS (X-ray photoelectron spectroscopy) analysis on the silica A obtained confirmed that a chemical bond Si-O-Si that bonded together the raw material silica and the functional group having an amino group was formed. Further performing FT-IR (Fourier transform type infrared spectroscopy) analysis confirmed that an amino group was contained. Thus, these two analyses confirmed that the silica A had a functional group having an amino group being fixed on a surface of the silica.

(Synthesis of Silica in Which Functional Group Having Halogeno Group Is Fixed on Surface (Silica C))

As a raw material silica, 1000 g of colloidal silica solution (concentration: 19.5mass%, average primary particle size: 35 nm, average secondary particle size: 68 nm) was prepared. In addition, 5 mmol (1.12 g) of (3-bromopropyl) trimethoxysilane, whichwas a silane coupling agent, was weighed out and dissolved in 50 g of methanol.

While the colloidal silica solution was being stirred at a rotational speed of stirring blade of 600 rpm at 25°C in an air atmosphere, the methanol solution of silane coupling agent mentioned above was dropped at a rate of 1 mL/min. After dropping, pH was adjusted using a pH-adjusting agent (KOH) so that the pH of the solution fell within a range from 8.0 to 9.0.

After the pH adjustment, the solution was left to stand for 8 hours in an air bath at 40°C, and was then left to stand for 12 hours in an air bath at 60°C. Thereafter, methanol was removed using a rotary evaporator to obtain silica C.

Performing XPS (X-ray photoelectron spectroscopy) analysis on the silica C obtained confirmed that a chemical bond Si-O-Si that bonded together the raw material silica and the functional group having a halogeno group was formed. Further performing FT-IR (Fourier transform type infrared spectroscopy) analysis confirmed that a halogeno group was contained. Thus, these twoanalyses confirmed that the silica C had a functional group having a halogeno group being fixed on a surface of the silica.

(Preparation of Polishing Composition)

Polishing compositions were each prepared by mixing together an abrasive grain (silica), a pH-adjusting agent, and an oxidizing agent in ultrapure water by compositions shown in Tables 1 to 4 (mixing temperature: approximately 25°C, mixing time: approximately 10 min.). The pH of each polishing composition was confirmed with a pH meter. A symbol "--" shown in Tables indicates that the listed component was not added.

Note that the silica B shown in Tables 1 to 4 is the raw material silica (colloidal silica; average primary particle size: 35 nm, average secondary particle size: 68 nm) before the functional group having an amino group is fixed on a surface of silica.

(Polishing Performance Evaluation)

Using the polishing compositions obtained, the polishing rates whenpolishing obj ects were polished under the following conditions were measured.

Note that the values shown in the polishing rate columns of Tables 1 to 4 are the measurement results of the polishing rates of silicon nitride (SiN), polycrystalline silicon (Poly-Si), or ruthenium (Ru).

Polishing conditions

Polishing machine: One-side CMP polishing machine for 200 mm
Pad: Polyurethane pad
Pressure: 2.5 psi (17.2 KPa)
Rotational speed of surface plate: 60 rpm
Rotational speed of carrier: 40 rpm
Flow rate of polishing composition: 100 mL/min. Polishing time: 1 min.

Polishing rates were calculated using the following equation:

[Mathematical Formula 1]

$$\text{Polishing rate [Å/min]} = \frac{\text{Film thickness before polishing [Å]} - \text{Film thickness after polishing [Å]}}{\text{Polishing time [min]}}$$

SiN and Poly-Si were each evaluated by obtaining the film thicknesses using a film thickness measurement tool based on optical interferometry, and then dividing a difference therebetween by the polishing time. Ru was evaluated by obtaining the film thicknesses by measuring sheet resistances using a direct current four-probe method, and then dividing a difference therebetween by the polishing time.

The measurement results of polishing rate are shown in Tables 1 to 4 below. Note that, in the present invention, a selection ratio (Poly-Si/SiN) obtained by dividing a polishing rate of Poly-Si by a polishing rate of SiN is preferably 1 or more, and more preferably 5 or more.

[Table 1]

| | Abrasive Grain | | pH-Adjusting Agent | | Oxidizing Agent | | pH | Polishing Rate (Å/min) | |
|---|---|---|---|---|---|---|---|---|---|
| | Abrasive Grain | Concentration (mass%) | pH-Adjusting Agent | Concentration (mass%) | Oxidizing Agent | Concentration (mass%) | | SiN | Poly-Si |
| Example 1 | Silica A | 10 | Nitric Acid | 0.7 | -- | -- | 3 | 6 | 53 |
| Comparative Example 1 | Silica B | 10 | Nitric Acid | 0.7 | -- | -- | 3 | 43 | 40 |

[Table 2]

| | Abrasive Grain | | pH-Adjusting Agent | | Oxidizing Agent | | pH | Polishing Rate (Å/min) |
| | Abrasive Grain | Concentration (mass%) | pH-Adjusting Agent | Concentration (mass%) | Oxidizing Agent | Concentration (mass%) | | Ru |
|---|---|---|---|---|---|---|---|---|
| Example 2 | Silica A | 10 | Nitric Acid | 0.7 | Hydrogen Peroxide | 0.34 | 3 | 142 |
| Comparative Example 2 | Silica B | 10 | Nitric Acid | 0.7 | Hydrogen Peroxide | 0.34 | 3 | 129 |

[Table 3]

| | Abrasive Grain | | pH-Adjusting Agent | | Oxidizing Agent | | pH | Polishing Rate (Å/min) |
|---|---|---|---|---|---|---|---|---|
| | Abrasive Grain | Concentration (mass%) | pH-Adjusting Agent | Concentration (mass%) | Oxidizing Agent | Concentration (mass%) | | Ru |
| Example 3 | Silica A | 10 | Potassium Hydroxide | 0.7 | Hydrogen Peroxide | 0.34 | 10 | 249 |
| Comparative Example 3 | Silica B | 10 | Potassium Hydroxide | 0.7 | Hydrogen Peroxide | 0.34 | 10 | 140 |

[Table 4]

| | Abrasive Grain | | pH-Adjusting Agent | | pH | Polishing Rate (Å/min) | | Selection Ratio Poly-Si/SiN |
|---|---|---|---|---|---|---|---|---|
| | Abrasive Grain | Concentration (mass%) | pH-Adjusting Agent | Concentration (mass%) | | Poly-Si | Sin | |
| Example 4 | Silica C | 10 | Nitric Acid | 0.7 | 3 | 53 | 6 | 8.8 |
| Example 5 | Silica C | 10 | Potassium Hydroxide | 0.7 | 10 | 838 | 56 | 15.0 |
| Comparative Example 1 | Silica B | 10 | Nitric Acid | 0.7 | 3 | 40 | 43 | 0.9 |
| Comparative Example 3 | Silica B | 10 | Potassium Hydroxide | 0.7 | 10 | 59 | 21 | 2.8 |

As is apparent from the results of polishing rate of Table 1 shown above, comparison between Example 1 and Comparative Example 1 has led to confirmation that the polishing rate of SiNwas reduced in Example 1. Inparticular, Example 1 showed that the polishing selectivity of Poly-Si to SiN was high (selection ratio = 8.8). Similarly, as is apparent from the results of polishing rate of Table 4 shown above, comparison between Examples 4 and 5 and Comparative Examples 1 and 3 has led to confirmation that Examples 4 and 5 provided higher polishing selectivity of Poly-Si to SiN. Thus, it has been shown that, according to a polishing composition of the present invention, the polishing rate of a Si-containing material can be controlled to a sufficient degree.

Moreover, from the results of polishing rate of Table 2 shown above, comparison between Example 2 and Comparative Example 2 has led to confirmation that Example 2 provided the improved polishing rate of Ru. Furthermore, from the results of polishing rate of Table 3 shown above, comparison between Example 3 and Comparative Example 3 has led to confirmation that Example 3 provided the improved polishing rate of Ru. Thus, it has been shown that a polishing composition of the present invention can provide a high polishing rate when ruthenium is polished.

**Claims**

1. Use of a polishing composition for polishing a polishing object having a layer comprising a Si-containing material selected from the group consisting of polycrystalline silicon and silicon nitride,
   wherein said polishing composition comprises:

   a silica in which a functional group satisfying condition (1) below is fixed on a surface thereof:

   Condition (1): the functional group has an amino group; and,
   a pH-adjusting agent.

2. The use according to claim 1, wherein the functional group having an amino group consists only of an amino group, or has a configuration in which an amino group is bonded to a linker structure,
   wherein said linker structure is a linear or branched alkylene group or oxyalkylene group or an arylene group, each having 2 to 5 carbon atoms, or a combination thereof.

3. A polishing method comprising the use according to claim 1.

4. A method for producing a substrate, the method comprising a step of polishing by using the polishing method according to claim 3.

**Europäisches Patentamt**
**European Patent Office**
**Office européen des brevets**

# EUROPEAN SEARCH REPORT

Application Number

EP 17 00 1186

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/081871 A1 (DYSARD JEFFREY [US] ET AL) 26 March 2009 (2009-03-26)<br>* claims 1,3,4,12,14,16,23-25 *<br>* paragraph [0031] * | 1-4 | INV.<br>C09K3/14<br>B24B37/04<br>C09G1/02<br>H01L21/321 |
| X | US 2009/081927 A1 (GRUMBINE STEVEN [US] ET AL) 26 March 2009 (2009-03-26)<br>* claims 1-4 *<br>* paragraphs [0029], [0046] * | 1-4 | H01L21/3105 |
| X | JP 2011 216582 A (FUJIFILM CORP) 27 October 2011 (2011-10-27)<br>* claims 1-4 *<br>* paragraph [0047] *<br>* paragraph [0122] * | 1-4 | |

TECHNICAL FIELDS
SEARCHED      (IPC)

C09K
C09G

The present search report has been drawn up for all claims

| Place of search | Date of completion of the search | Examiner |
|---|---|---|
| The Hague | 10 November 2017 | Domínguez Gutiérrez |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

ANNEX TO THE EUROPEAN SEARCH REPORT
ON EUROPEAN PATENT APPLICATION NO.

EP 3 260 515 A1

**ANNEX TO THE EUROPEAN SEARCH REPORT
ON EUROPEAN PATENT APPLICATION NO.**

EP 17 00 1186

This annex lists the patent family members relating to the patent documents cited in the above-mentioned European search report.
The members are as contained in the European Patent Office EDP file on
The European Patent Office is in no way liable for these particulars which are merely given for the purpose of information.

10-11-2017

| Patent document cited in search report | | | Publication date | Patent family member(s) | | | Publication date |
|---|---|---|---|---|---|---|---|
| US 2009081871 | A1 | | 26-03-2009 | CN | 101802125 | A | 11-08-2010 |
| | | | | EP | 2197972 | A2 | 23-06-2010 |
| | | | | IL | 203477 | A | 24-03-2013 |
| | | | | JP | 5519507 | B2 | 11-06-2014 |
| | | | | JP | 2010541203 | A | 24-12-2010 |
| | | | | KR | 20100074207 | A | 01-07-2010 |
| | | | | MY | 147729 | A | 15-01-2013 |
| | | | | TW | 200918658 | A | 01-05-2009 |
| | | | | US | 2009081871 | A1 | 26-03-2009 |
| | | | | WO | 2009042072 | A2 | 02-04-2009 |
| US 2009081927 | A1 | | 26-03-2009 | CN | 101802116 | A | 11-08-2010 |
| | | | | EP | 2188344 | A2 | 26-05-2010 |
| | | | | IL | 203476 | A | 30-04-2015 |
| | | | | JP | 5646996 | B2 | 24-12-2014 |
| | | | | JP | 6158777 | B2 | 05-07-2017 |
| | | | | JP | 2010541204 | A | 24-12-2010 |
| | | | | JP | 2015077681 | A | 23-04-2015 |
| | | | | JP | 2017123467 | A | 13-07-2017 |
| | | | | JP | 2017135387 | A | 03-08-2017 |
| | | | | KR | 20100065386 | A | 16-06-2010 |
| | | | | MY | 149975 | A | 15-11-2013 |
| | | | | SG | 184772 | A1 | 30-10-2012 |
| | | | | TW | 200923038 | A | 01-06-2009 |
| | | | | US | 2009081927 | A1 | 26-03-2009 |
| | | | | US | 2015184029 | A1 | 02-07-2015 |
| | | | | US | 2017051181 | A1 | 23-02-2017 |
| | | | | WO | 2009042073 | A2 | 02-04-2009 |
| JP 2011216582 | A | | 27-10-2011 | NONE | | | |

EPO FORM P0459

For more details about this annex : see Official Journal of the European Patent Office, No. 12/82

**EP 3 260 515 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4944836 A
- JP 2010041037 A
- JP 2008034818 A